(19) Europäisches Patentamt / European Patent Office / Office européen des brevets

(11) **EP 4 105 353 A1**

(12) **EUROPEAN PATENT APPLICATION**
published in accordance with Art. 153(4) EPC

(43) Date of publication:
**21.12.2022 Bulletin 2022/51**

(21) Application number: **21754307.3**

(22) Date of filing: **12.02.2021**

(51) International Patent Classification (IPC):
*C23C 14/34* (2006.01)  *C22C 1/04* (2006.01)
*C22C 19/07* (2006.01)  *C22C 33/02* (2006.01)
*C22C 38/00* (2006.01)  *H01F 41/18* (2006.01)
*H01L 43/08* (2006.01)  *H01L 43/10* (2006.01)

(52) Cooperative Patent Classification (CPC):
**C22C 1/04; C22C 19/07; C22C 33/02; C22C 38/00;
C23C 14/34; H01F 41/18; H01L 43/08; H01L 43/10**

(86) International application number:
**PCT/JP2021/005198**

(87) International publication number:
**WO 2021/162081 (19.08.2021 Gazette 2021/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.02.2020 JP 2020022183**

(71) Applicant: **Sanyo Special Steel Co., Ltd.
Himeji-shi, Hyogo 672-8677 (JP)**

(72) Inventors:
• **MATSUBARA, Noriaki
Himeji-shi, Hyogo 672-8677 (JP)**
• **HASEGAWA, Hiroyuki
Himeji-shi, Hyogo 672-8677 (JP)**

(74) Representative: **Müller-Boré & Partner
Patentanwälte PartG mbB
Friedenheimer Brücke 21
80639 München (DE)**

(54) **SPUTTERING TARGET MATERIAL AND METHOD FOR MANUFACTURING SAME**

(57)    An object of the present invention is to provide a sputtering target material having excellent crack resistance and a method of producing the same, and the present invention provides a sputtering target material and a method of producing the same, wherein the sputtering target material is composed of an alloy consisting of: B; one or more rare earth elements; and the balance consisting of Co and/or Fe and unavoidable impurities, wherein the amount of B in the alloy is 15 at.% or more and 30 at.% or less, wherein the one or more rare earth elements are selected from the group consisting of Pr, Nd, Sm, Gd, Tb, Dy, and Ho, and wherein the total amount of the one or more rare earth elements in the alloy is 0.1 at.% or more and 10 at.% or less.

[FIG.1]

EP 4 105 353 A1

**Description**

BACKGROUND OF THE INVENTION

Field of the Invention

The present invention relates to a sputtering target material. More specifically, the present invention relates to a sputtering target material that can be used suitably for producing a magnetic layer, and to a method of producing the sputtering target material.

Background Art

A magnetic tunnel junction (MTJ) device is used for a magnetic device such as a magnetic head or a magnetic random-access memory (MRAM). An MTJ device exhibits characteristics such as a high tunnel magnetoresistance (TMR) signal and a low switching current density (Jc).

A magnetic tunnel junction (MTJ) device has, for example, a structure in which a shielding layer composed of MgO is sandwiched between two magnetic layers composed of a Co-Fe-B alloy. A known material that forms this magnetic layer is a magnetic substance containing boron (B). Such a magnetic substance is composed of, for example, Co-B, Fe-B, Co-Fe-B, or such a component having Al, Cu, Mn, Ni, or the like added thereto.

A magnetic layer constituting a magnetic tunnel junction (MTJ) device is usually given by a sputtering process performed with a target material containing a Co-Fe-B-based alloy. JP 2004-346423 A (Patent Literature 1) discloses a Co-Fe-B-based alloy target material having boride phases microdispersed in the cross-sectional microstructure of the material. WO2015-080009 (Patent Literature 2) discloses a magnetic sputtering target material containing high-concentration B phases and low-concentration B phases, in which material the high-concentration B phases are finely dispersed.

JP 2017-057477 A (Patent Literature 3) discloses a sputtering target material in which the formation of $(CoFe)_3B$, $Co_3B$, and $Fe_3B$ is reduced. WO2016-140113 (Patent Literature 4) discloses a magnetic sputtering target material the oxygen content of which is 100 atppm or less.

In recent years, further enhanced performance has been desired for MTJ devices. JP 2017-82330 A (Patent Literature 5) and JP 2014-156639 A (Patent Literature 6) disclose a sputtering target material composed of an alloy that contains a rare earth (lanthanoid) element and is to be used for a soft magnetic film layer.

Citation List

Patent Literature

    Patent Literature 1: JP 2004-346423 A
    Patent Literature 2: WO2015-080009
    Patent Literature 3: JP 2017-057477 A
    Patent Literature 4: WO2016-140113
    Patent Literature 5: JP 2017-82330 A
    Patent Literature 6: JP 2014-156639 A

SUMMARY OF THE INVENTION

Technical Problem

As described in Patent Literature 5 and 6, addition of a rare earth element to a CoFe alloy constituting a target material leads to enhancement of the magnetic performance of the resulting magnetic layer and allows the MTJ device to give a high TMR signal. However, a target material composed of an alloy containing a rare earth element is very brittle, and thus, is broken more easily during the production or usage of the target material, posing a problem of inhibiting the productivity.

An object of the present invention is to provide: a sputtering target material that is composed of a Co-Fe-B-based alloy containing a rare earth element and has excellent crack resistance; and a method of producing the sputtering target material.

Solution to Problem

A target material formed by sintering a Co-Fe-B-based alloy powder has a metallographic structure formed therein and containing CoFe phases that are alloy phases. The CoFe phases contribute to enhancement of the toughness of the target material. The present inventors have studied vigorously and, as a result, have completed the present invention based on the findings that addition of a rare earth element(s) generates intermetallic compounds composed of CoFe phases responsible for the toughness and the rare earth element(s).

That is, a sputtering target material according to the present invention is composed of an alloy consisting of: B; one or more rare earth elements (hereinafter referred to as "the rare earth element(s) RE" or simply "the RE"); and the balance consisting of Co and/or Fe and unavoidable impurities. The amount of B in the alloy is 15 at.% or more and 30 at.% or less. One or more rare earth elements selected from the group consisting of Pr, Nd, Sm, Gd, Tb, Dy, and Ho are used as the rare earth element(s) RE. The total amount of the rare earth element(s) RE in the alloy is 0.1 at.% or more and 10 at.% or less. In cases where one rare earth element selected from the group consisting of Pr, Nd, Sm, Gd, Tb, Dy, and Ho is used as the rare earth element(s) RE, the total amount of the rare earth element(s) RE means the amount of the one rare earth element (the same applies hereinafter). In cases where two or more rare earth elements selected from the above-mentioned group are used as the rare earth element(s) RE, the total amount of the rare earth element(s) RE means the total amount of the two or more rare earth elements (the same applies hereinafter).

In a field of view that is selected randomly and has an area of 3250 $\mu m^2$, the number of intermetallic compound phases is preferably 1 or less, wherein the intermetallic compound phases are each formed from Co and/or Fe and the rare earth element(s) RE, and wherein the intermetallic compound phases each have a maximum inscribed circle diameter of 5 $\mu m$ or more.

From another viewpoint, a method of producing a sputtering target material according to the present invention includes a sintering step of sintering a raw material powder composed of an alloy consisting of: B; a rare earth element(s) RE; and the balance consisting of Co and/or Fe and unavoidable impurities. In the production method, the amount of B in the alloy is 15 at.% or more and 30 at.% or less. One or more rare earth elements selected from the group consisting of Pr, Nd, Sm, Gd, Tb, Dy, and Ho are used as the rare earth element(s) RE. The total amount of the rare earth element(s) RE in the alloy is 0.1 at.% or more and 10 at.% or less.

Advantageous Effects of Invention

The sputtering target material according to the present invention is composed on the alloy containing suitable amounts of boron and a rare earth element(s). The target material has excellent crack resistance. The target material makes it possible to avoid damage during the production of the target material and during the sputtering with the target material. The target material provides a high production efficiency. A magnetic film given by sputtering with the target material has excellent magnetic performance. The target material makes it possible to efficiently obtain a high-performance and high-quality magnetic film. The target material is suitable for producing a magnetic film to be used for a magnetic device such as a magnetic head or an MRAM.

From another viewpoint, the production method according to the present invention makes it possible to obtain a magnetic film having higher magnetic performance and to efficiently and conveniently produce a target material having excellent crack resistance.

BRIEF DESCRIPTION OF THE DRAWINGS

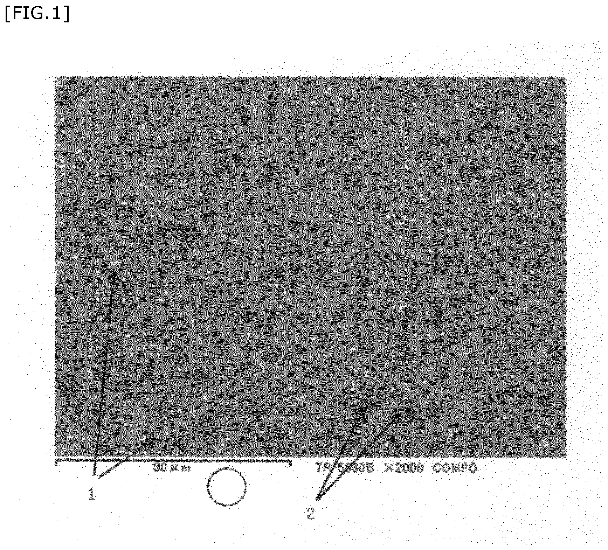

FIG. 1 is a scanning-electron-microscopical image illustrating a metallographic structure of an alloy constituting a sputtering target material according to one embodiment of the present invention.

DETAILED DESCRIPTION OF THE EMBODIMENTS

Below, the present invention will be described in detail with reference to preferable embodiments. As used herein, the expression "X to Y" denoting a range means "X or more and Y or less".

The sputtering target material according to the present invention is composed of an alloy consisting of: B; a rare earth element(s) RE; and the balance consisting of Co and/or Fe and unavoidable impurities. In other words, the alloy is a Co-Fe-B-based alloy, Co-B-based alloy, or Fe-B-based alloy that contains a rare earth element(s) RE. In the present invention, one or more rare earth elements selected from the group consisting of Pr, Nd, Sm, Gd, Tb, Dy, and Ho are used as the rare earth element(s) RE. The rare earth element(s) RE can contribute to enhancement of the magnetic performance of the resulting magnetic film. To the extent that the effects of the present invention are not impaired, the alloy can contain another element(s) as an optional component(s). Examples of unavoidable impurities include O, S, C, N, and the like.

The amount of B in the alloy is 15 at.% or more and 30 at.% or less. Adjusting the amount of B to 15 at.% or more gives sufficient amorphism to the resulting magnetic film. The magnetic film has excellent magnetic performance. Adjusting the amount of B to 30 at.% or less makes it possible to form a metallographic structure containing CoFe phases, Co phases, or Fe phases even in cases where a rare earth element(s) RE is/are added. A metallographic structure containing CoFe phases can be formed in a Co-Fe-B-based alloy. A metallographic structure containing Co phases can be formed in a Co-B-based alloy. A metallographic structure containing Fe phases can be formed in an Fe-B-based alloy.

The total amount of the rare earth element(s) RE in the alloy is 0.1 at.% or more and 10 at.% or less. In cases where the alloy contains two or more selected from the group consisting of Pr, Nd, Sm, Gd, Tb, Dy, and Ho, the total amount of the two or more elements is 0.1 at.% or more and 10 at.% or less. Adjusting the total amount of the rare earth element(s) RE to 0.1 at.% or more makes it possible to sufficiently achieve the effect of enhancing the performance of the resulting magnetic film. Adjusting the total amount of the rare earth element(s) RE to 10 at.% or less prevents the inhibition of the formation of CoFe phases, Co phases, or Fe phases in the metallographic structure.

The sputtering target material according to the present invention is composed of the alloy that contains suitable amounts of boron B and a rare earth element(s) RE. In the metallographic structure of the alloy, the formation of CoFe phases, Co phases, or Fe phases has not been inhibited. The CoFe phases, Co phases, or Fe phases in the metallographic structure contribute to enhancement of the toughness of the target material and enhancement of the magnetic performance of the resulting magnetic film. The target material has excellent crack resistance during the production and usage of the target material. Sputtering with the target material makes it possible to efficiently produce a magnetic film having high magnetic performance. Incorporating the magnetic film allows the MTJ device to give a high TMR signal. The target material is suitable for producing a magnetic film to be used for a magnetic device such as a magnetic head or an MRAM.

The alloy constituting the sputtering target material is preferably represented by the following compositional formula.

$$(1-y-z)(Co-xFe)-yB-zRE$$

In the compositional formula, x is the ratio (at.%) of the Fe content to the total of the Co content and the Fe content in the alloy. To the extent that the effects of the present invention are obtained, x can be selected suitably in the range of 0 at.% or more and 100 at.% or less. In the compositional formula, (1-x) before Co has been omitted. In one embodiment, x is 0 at.%. In another embodiment, x is 100 at.%. In yet another embodiment, x is more than 0 at.% and less than 100 at.%. x is, for example, 10 at.% or more and 98 at.% or less, or 15 at.% or more and 95 at.% or less.

In the compositional formula, the RE represents one or more rare earth elements selected from the group consisting of Pr, Nd, Sm, Gd, Tb, Dy, and Ho. y is the ratio (at.%) of the B content to the total of the Co content, the Fe content, the B content, and the RE content (that is, the total amount of one or more rare earth elements selected from the group consisting of Pr, Nd, Sm, Gd, Tb, Dy, and Ho), and z is the ratio (at.%) of the RE content to the total of the Co content, the Fe content, the B content, and the RE content.

In the target material according to the present invention, y is 15 at.% or more and 30 at.% or less. From the viewpoint of magnetic characteristics, y is more preferably 16 at.% or more, 17 at.% or more, 18 at.% or more, 19 at.% or more, or 20 at.% or more.

In the target material according to the present invention, z is 0.1 at.% or more and 10 at.% or less. From the viewpoint of magnetic characteristics, z is more preferably 0.5 at.% or more, 1 at.% or more, 2 at.% or more, or 3 at.% or more.

A metallographic structure containing (CoFe)RE phases can be formed in a Co-Fe-B-based alloy, Co-B-based alloy, or Fe-B-based alloy that is represented by the above-mentioned compositional formula and contains the rare earth element(s) RE. The (CoFe)RE phases are phases of an intermetallic compound (CoFe)RE formed by reaction between the rare earth element(s) RE and Co and/or Fe. The ratio between Co and/or Fe and RE in the (CoFe)RE phases varies depending on the type(s) of the rare earth element(s) RE. Herein, an intermetallic compound formed from Co and/or Fe and the rare earth element(s) RE is defined as (CoFe)RE, independent of the ratio.

In the metallographic structure of the Co-Fe-B-based alloy containing the rare earth element(s) RE, the formation and increase of the (CoFe)RE phases result in the decrease and disappearance of the CoFe phases, Co phases, or Fe phases that are responsible for the toughness of the target material. The decrease and disappearance of the CoFe phases, Co phases, or Fe phases decrease the crack resistance of the target material. It is preferable that the target material has a metallographic structure in which the formation and increase of the (CoFe)RE phases have been inhibited, and which does not inhibit the toughness derived from the CoFe phases, Co phases, or Fe phases.

As the metallographic structure formed in the target material is observed using a scanning electron microscope (SEM), the number of (CoFe)RE phases in a field of view selected randomly and having a length of 50 μm and a width of 65 μm (having an area of 3250 μm²) is preferably 1 or less, wherein the (CoFe)RE phases each have a maximum inscribed circle diameter of 5 μm or more. The expression "the number of (CoFe)RE phases each having a maximum inscribed circle diameter of 5 μm or more is 1 or less" means, in other words, that the formation and increase of the (CoFe)RE phases in the metallographic structure have been inhibited. In the target material having the metallographic structure, the toughness derived from the CoFe phases, Co phases, or Fe phases is not inhibited. The target material has excellent crack resistance. From this viewpoint, "the number of (CoFe)RE phases each having a maximum inscribed circle diameter of 5 μm or more" is more preferably 0.

The diameter of the maximum inscribed circle that can be described in each of the (CoFe)RE phases is measured by processing an SEM image of a test piece taken from a target material. The image can be processed using a commercially available image analysis software item.

FIG. 1 is a part of a scanning-electron-microscopical image obtained of a target material according to a preferable embodiment of the present invention. In FIG. 1, the white portions are the (CoFe)RE phases. In the SEM image, the largest (CoFe)RE phases are denoted by arrow 1. The diameter of the maximum inscribed circle that can be described in each of the largest (CoFe)RE phases is less than 5 μm. The dark-color portions denoted by arrow 2 are the boride phases formed from Co, Fe and B (CoFe boride phases) or the CoFe phases. Below the image, a circle having a diameter of 5 μm is given for comparison. In this regard, FIG. 1 is a scanning-electron-microscopical image related to a target material containing Co and Fe (target material No.5 in the below-mentioned Examples), and thus, the dark-color portions denoted by arrow 2 represent the boride phases formed from Co, Fe and B (CoFe boride phases) or the CoFe phases. In the case of a scanning-electron-microscopical image related to a target material containing Co but not containing Fe, the dark-color portions denoted by arrow 2 represent the boride phases formed from Co and B (Co boride phases) or the Co phases. In the case of a scanning-electron-microscopical image related to a target material containing Fe but not containing Co, the dark-color portions denoted by arrow 2 represent the boride phases formed from Fe and B (Fe boride phases) or the Fe phases.

As used herein, the expression "the number of (CoFe)RE phases each having a maximum inscribed circle diameter of 5 μm or more" is determined as follows: a test piece is observed under a microscope; a field of view having, for example, a length of 50 μm and a width of 65 μm, is selected randomly so as to have a field-of-view area of 3250 μm$^2$; and the (CoFe)RE phases each having a maximum inscribed circle diameter of 5 μm or more are counted.

To the extent that the effects of the present invention can be obtained, the metallographic structure may have another phase(s) other than the (CoFe)RE phases. Examples of the other phase(s) include a (CoFe)$_2$B phase(s), a CoFe phase(s), a Co phase(s), an Fe phase(s), and the like. In this regard, the (CoFe)$_2$B phase means a phase in which the ratio of the sum of the Co content and the Fe content (the Co content + the Fe content) to the B content [(the Co content + the Fe content): the B content] is 2:1 in terms of atomic ratio.

It is preferable that the bending strength of the sputtering target material according to the present invention is larger. The bending strength of the sputtering target material according to the present invention is, for example, 180 MPa or more, 190 MPa or more, 200 MPa or more, 210 MPa or more, or 220 MPa or more. In this regard, the bending strength can be measured using the method described in the EXAMPLES.

A method of producing the sputtering target material according to the present invention includes a sintering step of sintering a raw material powder. More specifically, the production method includes a step of forming a sintered product by so-called powder metallurgy, in which a powder as a raw material is heated under high pressure to be solidified and molded. The sintered product is processed into a suitable shape with a mechanical means or the like to give a target material.

The raw material powder is composed of many particles. In the production method according to the present invention, each particle constituting the raw material powder is composed of an alloy consisting of: B; a rare earth element(s) RE, and the balance consisting of Co and/or Fe and unavoidable impurities. The amount of B in the alloy is 15 at.% or more and 30 at.% or less. One or more rare earth elements selected from the group consisting of Pr, Nd, Sm, Gd, Tb, Dy, and Ho are used as the rare earth element(s) RE. The total amount of the rare earth element(s) RE in the alloy is 0.1 at.% or more and 10 at.% or less. In this regard, the above descriptions about the alloy constituting the sputtering target material according to the present invention apply to the alloy constituting the raw material powder.

In the production method, the raw material powder containing boron B and the rare earth element(s) RE in the above-mentioned respective ranges of amounts is used, hence inhibiting the formation and increase of the (CoFe)RE phases in the metallographic structure of a target material given by sintering the raw material powder. In the metallographic structure of the target material, the CoFe phases, Co phases, or Fe phases contributive to the toughness are formed suitably. The target material given by the production method has excellent crack resistance. The production method makes it possible to avoid damage to the target material during the production.

The raw material powder can be produced using an atomization method. The type of the atomization method is not particularly limited, and may be a gas atomization method, water atomization method, or centrifugal atomization method. The atomization method is performed using a known atomizing device and production conditions, in which the device and the conditions are selected suitably.

The raw material powder preferably undergoes sieve classification before the sintering step. The purpose of the sieve classification is to remove particles (coarse powder) that have a particle diameter of 500 μm or more and inhibit sintering. Using the raw material powder makes it possible to obtain the effects of the present invention even in cases where no particle diameter adjustment other than the coarse powder removal is performed.

In the production of the target material, the method or conditions for solidifying and molding the raw material powder to obtain a sintered product are not particularly limited. For example, a hot isostatic pressing (HIP) method, hot pressing method, spark plasma sintering (SPS) method, hot extrusion method, or the like is selected suitably. In addition, the method for processing the resulting sintered product is not particularly limited, and can be performed using a known mechanical processing means.

The target material obtained using the production method according to the present invention is used suitably, for example, for sputtering for forming a magnetic thin film to be used for an MTJ device. Although the target material contains a rare earth element(s), the crack and the like of the target material is inhibited during the sputtering with the target material. This makes it possible to efficiently obtain a high-performance and high-quality magnetic film suitable for a magnetic device such as a magnetic head and an MRAM.

EXAMPLES

Below, the effects of the present invention will be described with reference to Examples, but the present invention is not to be construed as limited to the description of these Examples.

[Production of raw material powder]

The raw materials were each weighed out in accordance with the compositions listed in Tables 1 and 2, introduced into a crucible composed of a refractory material, and melted by induction heating under reduced pressure in an Ar gas atmosphere or vacuum atmosphere. Then, a melted material was allowed to flow out through a small hole (having a diameter of 8 mm) provided in the lower part of the crucible, and gas-atomized with high-pressure Ar gas to give a raw material powder for producing a target material.

[Production of sputtering target material]

The resulting raw material powder was sintered using the below-mentioned procedure to produce target materials Nos.1 to 12 in Inventive Examples and target materials Nos. 13 to 15 in Comparative Examples.

First, the raw material powder given using a gas atomization method underwent sieve classification, which removed coarse powder having a diameter of 500 $\mu$m or more. Next, the raw material powder after the sieve classification was packed in a can (having an outer diameter of 220 mm, an inner diameter of 210 mm, and a length of 200 mm) formed of carbon steel. The raw material powder was then vacuum-degassed and sintered using an HIP device under the conditions based on a temperature of 900 to 1200°C, a pressure of 100 to 150 MPa, and a holding time of 1 to 5 hours to produce a sintered product. The resulting sintered product underwent wire-cutting, lathing, and plane-polishing so as to be processed in the shape of a disc having a diameter of 180 mm and a thickness of 7 mm. The disc was used as a sputtering target material.

[Observation under scanning electron microscope]

A test piece was taken from each of target materials Nos. 1 to 12 in Inventive Examples and target materials Nos. 13 to 15 in Comparative Examples, and the cross section of each test piece was polished. The cross section of each test piece was observed under a scanning electron microscope (SEM), and five fields of view each having a length of 50 $\mu$m and a width of 65 $\mu$m (having an area of 3250 $\mu$m$^2$) were photographed as reflection electron images. Then, an image analysis was performed to measure the diameter of the maximum inscribed circle that can be described in each of the phases of the intermetallic compound (CoFe)RE. The number of the (CoFe)RE phases each having the diameter of 5 $\mu$m or more was recorded. The results obtained are tabulated as the number N of the inscribed circles in Tables 1 and 2 below. The number N is the average of the values measured in the five fields of view.

[Evaluation of crack resistance]

The crack resistance of each of the sputtering target materials was evaluated on the basis of the bending strength measured using the below-mentioned procedure.

First, a test piece was cut out of each of target materials Nos. 1 to 12 in Inventive Examples and target materials Nos. 13 to 15 in Comparative Examples by wire-cutting. Then, a bending test was performed in accordance with the provisions of JIS Z 2511 "Metallic powders - Determination of green strength by transverse rupture of rectangular compacts". The test conditions are as below-mentioned.

Shape of test piece: 2 mm in thickness, 2 mm in width, and 20 mm in length
Distance between supports: 10 mm

The load (kN) that caused the test piece to be fractured was measured, and the bending strength (MPa) was calculated in accordance with the following mathematical formula. The averages each of which was obtained from the values of three measurements are tabulated in Tables 1 and 2 below.

$$BS = (3 / 2) \times P \times L / (t^2 \times W)$$

BS: bending strength (MPa)
t: thickness (mm) of test piece
W: width (mm) of test piece
L: distance (mm) between supports
P: Load (kN) that caused fracture

[Table 1]

Table 1 Inventive Examples

| No. | Composition (at.%) | | | | | | | | | | | Number N of inscribed circle | Bending strength [MPa] |
| | Co | Fe | B | RE | | | | | | | | | |
| | | | | Subtotal | Pr | Nd | Sm | Gd | Tb | Dy | Ho | | |
|---|---|---|---|---|---|---|---|---|---|---|---|---|---|
| 1 | 44.9 | 40 | 15 | 0.1 | 0.1 | 0 | 0 | 0 | 0 | 0 | 0 | 0 | 620 |
| 2 | 32 | 45 | 22 | 1 | 0 | 1 | 0 | 0 | 0 | 0 | 0 | 0 | 350 |
| 3 | 38 | 30 | 30 | 2 | 0 | 0 | 0 | 0 | 0 | 0 | 2 | 0 | 280 |
| 4 | 20 | 55 | 19 | 6 | 0 | 0 | 0 | 0 | 6 | 0 | 0 | 0 | 250 |
| 5 | 5 | 70 | 21 | 4 | 0 | 0 | 0 | 0 | 0 | 4 | 0 | 0 | 260 |
| 6 | 56 | 10 | 30 | 4 | 0 | 0 | 2 | 2 | 0 | 0 | 0 | 0 | 220 |
| 7 | 12 | 60 | 18 | 10 | 0 | 0 | 0 | 0 | 0 | 10 | 0 | 1 | 180 |
| 8 | 38 | 40 | 16 | 6 | 0 | 2 | 0 | 0 | 2 | 0 | 2 | 1 | 190 |
| 9 | 21 | 50 | 25 | 4 | 1 | 0 | 1 | 0 | 0 | 2 | 0 | 0 | 240 |
| 10 | 25 | 50 | 17 | 8 | 0 | 2 | 0 | 2 | 4 | 0 | 0 | 0 | 200 |
| 11 | 0 | 75 | 22 | 3 | 0 | 0 | 1 | 0 | 0 | 2 | 0 | 0 | 240 |
| 12 | 76 | 0 | 19 | 5 | 0 | 2 | 0 | 2 | 0 | 1 | 0 | 0 | 220 |

[Table 2]

Table 2 Comparative Examples

| No. | Composition (at.%) | | | | | | | | | | | Number N of inscribed circle | Transverse strength [MPa] |
| | Co | Fe | B | RE | | | | | | | | | |
| | | | | Subtotal | Pr | Nd | Sm | Gd | Tb | Dy | Ho | | |
|---|---|---|---|---|---|---|---|---|---|---|---|---|---|
| 13 | 43 | 20 | <u>32</u> | 5 | 0 | 0 | 5 | 0 | 0 | 0 | 0 | 3 | 90 |
| 14 | 11 | 60 | 18 | <u>11</u> | 0 | 0 | 0 | 0 | 11 | 0 | 0 | 5 | 60 |
| 15 | 23 | 35 | 28 | <u>14</u> | 0 | 0 | 0 | 4 | 0 | 8 | 2 | 6 | 40 |

One of the SEM images of five fields of view photographed in target material No.5 in Examples is given in FIG. 1. The white portions denoted by arrows in FIG. 1 are the (CoFe)RE phases. As indicated in Table 1, in the metallographic structure of the target material No. 5 in Inventive Examples, the number N of the (CoFe)RE phases each having a maximum inscribed circle diameter of 5 $\mu$m or more is 0 in the field of view having a length of 50 $\mu$m and a width of 65 $\mu$m (having an area of 3250 $\mu$m$^2$).

Target materials Nos. 1 to 12 in Inventive Examples and target materials Nos. 13 to 15 in Comparative Examples were used for sputtering with a DC magnetron sputter. The sputtering conditions are as below-mentioned.

Substrate: aluminium substrate (having a diameter of 95 mm and a thickness of 1.75 mm)
Atmosphere in chamber: argon gas
Pressure in chamber: 0.9 Pa

After the sputtering, the state of each target material was observed visually.

Target materials Nos. 1 to 12 in Inventive Examples caused no recognizable crack during the sputtering. In contrast, target materials Nos. 13 to 15 having a bending strength of 90 MPa or less in Comparative Examples caused a recognizable crack(s) after the sputtering.

As described above, the target materials in Inventive Examples were evaluated more highly than the target materials in Comparative Examples. From these evaluation results, the superiority of the present invention is clear.

Industrial Applicability

A sputtering target material described above can be used to produce a magnetic layer in various applications.

Reference Signs List

1    (CoFe)RE phases
2    CoFe boride phases or CoFe phases

**Claims**

1.  A sputtering target material composed of an alloy consisting of:

    B;
    one or more rare earth elements; and
    the balance consisting of Co and/or Fe and unavoidable impurities,
    wherein an amount of B in the alloy is 15 at.% or more and 30 at.% or less,
    wherein the one or more rare earth elements are selected from the group consisting of Pr, Nd, Sm, Gd, Tb, Dy, and Ho, and
    wherein a total amount of the one or more rare earth elements in the alloy is 0.1 at.% or more and 10 at.% or less.

2.  The sputtering target material according to claim 1,

    wherein, in a field of view that is selected randomly and has an area of 3250 $\mu$m$^2$, the number of intermetallic compound phases is 1 or less,
    wherein the intermetallic compound phases are each formed from Co and/or Fe and the one or more rare earth elements, and
    wherein the intermetallic compound phases each have a maximum inscribed circle diameter of 5 $\mu$m or more.

3.  A method of producing a sputtering target material, the method comprising a sintering step of sintering a raw material powder composed of an alloy consisting of:

    B;
    one or more rare earth elements; and
    the balance consisting of Co and/or Fe and unavoidable impurities,
    wherein an amount of B in the alloy is 15 at.% or more and 30 at.% or less,

wherein the one or more rare earth elements are selected from the group consisting of Pr, Nd, Sm, Gd, Tb, Dy, and Ho, and
wherein a total amount of the one or more rare earth elements in the alloy is 0.1 at.% or more and 10 at.% or less.

[FIG.1]

**INTERNATIONAL SEARCH REPORT**

| International application No. |
|---|
| PCT/JP2021/005198 |

### A. CLASSIFICATION OF SUBJECT MATTER

C23C 14/34(2006.01)i; C22C 1/04(2006.01)i; C22C 19/07(2006.01)i; C22C
33/02(2006.01)i; C22C 38/00(2006.01)i; H01F 41/18(2006.01)i; H01L
43/08(2006.01)i; H01L 43/10(2006.01)i
FI:      C23C14/34 A; C22C1/04 H; C22C33/02 J; C22C19/07 C; C22C38/00
         303Z; H01F41/18; H01L43/08 Z; H01L43/10

According to International Patent Classification (IPC) or to both national classification and IPC

### B. FIELDS SEARCHED

Minimum documentation searched (classification system followed by classification symbols)
C23C14/34; C22C1/04; C22C19/07; C22C33/02; C22C38/00; H01F41/18;
H01L43/08; H01L43/10

Documentation searched other than minimum documentation to the extent that such documents are included in the fields searched
Published examined utility model applications of Japan     1922–1996
Published unexamined utility model applications of Japan   1971–2021
Registered utility model specifications of Japan           1996–2021
Published registered utility model applications of Japan   1994–2021

Electronic data base consulted during the international search (name of data base and, where practicable, search terms used)
CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 1-156466 A (YASKAWA ELECTRIC CORPORATION) 20 June 1989 (1989-06-20) page 2, upper left column, line 6 to upper right column, line 2, table 1, in particular, example no. 7, 8 | 1<br>2-3 |
| Y<br>A | WO 2014/115375 A1 (JX NIPPON MINING & METALS CORP.) 31 July 2014 (2014-07-31) paragraphs [0006], [0011]-[0012], [0026]-[0032] | 2-3<br>1 |
| Y<br>A | JP 2012-207274 A (HITACHI METALS, LTD.) 25 October 2012 (2012-10-25) paragraphs [0013]-[0014], [0022]-[0024] | 2-3<br>1 |

☒  Further documents are listed in the continuation of Box C.      ☒  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 29 March 2021 (29.03.2021) | 13 April 2021 (13.04.2021) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

| International application No. |
| --- |
| PCT/JP2021/005198 |

C (Continuation).   DOCUMENTS CONSIDERED TO BE RELEVANT

| Category* | Citation of document, with indication, where appropriate, of the relevant passages | Relevant to claim No. |
| --- | --- | --- |
| P, X<br>P, A | CN 111364013 A (BENGBU TAIXIN MATERIAL TECHNOLOGY CO., LTD.) 03 July 2020 (2020-07-03) paragraphs [0010], [0012], [0024], [0026], [0028], [0032] | 1<br>2-3 |

Form PCT/ISA/210 (continuation of second sheet) (January 2015)

INTERNATIONAL SEARCH REPORT

Information on patent family members

International application No.

PCT/JP2021/005198

| Patent Documents referred in the Report | Publication Date | Patent Family | Publication Date |
|---|---|---|---|
| JP 1-156466 A | 20 Jun. 1989 | (Family: none) | |
| WO 2014/115375 A1 | 31 Jul. 2014 | US 2015/0262752 A1 paragraphs [0006], [0017]-[0026], [0046]-[0053] EP 2857547 A1 CN 105026607 A | |
| JP 2012-207274 A | 25 Oct. 2012 | (Family: none) | |
| CN 111364013 A | 03 Jul. 2020 | (Family: none) | |

Form PCT/ISA/210 (patent family annex) (January 2015)

**EP 4 105 353 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004346423 A
- WO 2015080009 A
- JP 2017057477 A
- WO 2016140113 A
- JP 2017082330 A
- JP 2014156639 A